# EUROPÄISCHE PATENTSCHRIFT

(11) **EP 2 740 155 B1**
(45) Veröffentlichungstag und Bekanntmachung des Hinweises auf die Patenterteilung: **01.05.2019**
(21) Anmeldenummer: 12737284.5
(22) Anmeldetag: 19.07.2012
(51) Int. Cl.: H01L 29/872, H01L 29/06, H01L 21/329

(54) **SUPER-JUNCTION-SCHOTTKY-PIN-DIODE**
SUPER-JUNCTION-SCHOTTKY-PIN-DIODE
DIODE PIN SCHOTTKY À SUPERJONCTION

(30) Priorität: 02.08.2011 DE 102011080258
(43) Veröffentlichungstag der Anmeldung: 11.06.2014
(73) Patentinhaber: Robert Bosch GmbH, 70442 Stuttgart (DE)
(72) Erfinder: QU, Ning, 72770 Reutlingen (DE); GOERLACH, Alfred, 72127 Kusterdingen (DE)
(86) Internationale Anmeldenummer: PCT/EP2012/064146
(87) Internationale Veröffentlichungsnummer: WO 2013/017413

(56) Entgegenhaltungen:
- DE-C2- 19 740 195
- US-A- 5 216 275
- US-A1- 2010 237 456
- US-B1- 6 590 240
- RAJESH N GUPTA ET AL: "A Novel Planarized, Silicon Trench Sidewall Oxide-Merged p-i-n Schottky (TSOX-MPS) Rectifier", IEEE ELECTRON DEVICE LETTERS, IEEE SERVICE CENTER, NEW YORK, NY, US, Bd. 20, Nr. 12, 1. Dezember 1999 (1999-12-01), XP011018697, ISSN: 0741-3106
- NAPOLI E ET AL: "Design consideration of 1000V merged PiN Schottky diode using superjunction sustaining layer", PROCEEDINGS OF THE 13TH. INTERNATIONAL SYMPOSIUM ON POWER SEMICONDUCTOR DEVICES & ICS. ISPSD'01. OSAKA, JAPAN, JUNE 4 - 7, 2001; [INTERNATIONAL SYMPOSIUM ON POWER SEMICONDUCTOR DEVICES & IC'S], NEW YORK, NY : IEEE, US, 4 June 2001 (2001-06-04), pages 339-342, XP010551635, DOI: 10.1109/ISPSD.2001.934624 ISBN: 978-4-88686-056-9

## Beschreibung

### Stand der Technik

Im Rahmen der CO₂-Thematik werden zunehmend effiziente Stromumrichter benötigt. Beispiele sind Wechselrichter (Inverter) für Photovoltaik- oder Automobilanwendungen. Dazu sind hoch sperrende, verlustarme und schnell schaltende Leistungshalbleiter notwendig. Neben aktiven Halbleiterschaltern wie IGBTs oder CoolMOS-Transistoren sind auch Freilaufdioden erforderlich. Für Hochspannungsanwendungen werden in der Regel PiN-Dioden aus Silizium eingesetzt. PiN-Dioden weisen kleine Durchlassspannungen und niedrige Sperrströme und damit geringe Vorwärts- und Sperrverluste auf. Nachteilig sind allerdings hohe Schaltverluste, die bei der Stromkommutierung als Abschaltverluste auftreten.

Hochspannungs-PiN-Dioden sind PN-Dioden, bei denen sich zwischen p- und n-Gebiet eine undotierte (intrinsische) und in der Praxis meist schwach dotierte Schicht i befindet. Die Sperrspannung wird hauptsächlich von dem schwach dotierten Gebiet i übernommen. Die Raumladungszone dehnt sich hauptsächlich in dem schwach dotierten Gebiet aus. Die Dotierkonzentration und die Dicke dieses schwach dotierten Gebiets werden von der vorgegebenen Durchbruchspannung bestimmt. Eine hohe Durchbruchspannung bedeutet niedrige Dotierkonzentration und große Dicke dieses schwach dotierten Gebiets. Für eine 600V-Diode beträgt die Dotierungskonzentration der i-Schicht etwa 3.10¹⁴cm⁻³ und die Schichtdicke etwa 50 Mikrometer.

Bei Flussbetrieb mit hoher Stromdichte tritt in PiN-Dioden eine Hochinjektion auf. Dabei werden Elektronen und Löcher in das schwach dotierte Gebiet injiziert. Die Konzentration der injizierten Minoritätsladungsträger übersteigt dabei die Dotierkonzentration des schwach dotierten Gebiets. Die Leitfähigkeit des schwach dotierten Gebiets wird dadurch stark erhöht. Damit bleibt der Spannungsabfall am schwach dotierten Mittelgebiet gering. Die Flussspannung bei hohen Strömen bleibt niedrig. Im Gegensatz dazu findet bei Majoritätsträgerbauelementen wie beispielsweise Schottky-Dioden keine Anhebung der Ladungsträgerdichte statt. Das schwach dotierte Gebiet stellt einen großen ohmschen Widerstand dar, an dem in Flussrichtung eine entsprechend hohe Spannung abfällt.

Die Ladungsträger (Elektronen und Löcher), die während des Betriebs von PN- oder PiN-Dioden in Flussrichtung in das schwach dotierte Gebiet injiziert werden, müssen beim Abschalten zuerst abgebaut werden, bevor die Diode Sperrspannung übernehmen kann. Daher fließt der Strom bei einer abrupten Stromkommutierung zunächst in Sperrrichtung weiter, bis die gespeicherten Ladungsträger abgebaut bzw. ausgeräumt sind. Dieser Strom wird auch als Ausräumstrom oder Reverse Recovery Current bezeichnet. Die Höhe und Dauer des Ausräumstroms wird in erster Linie von der Menge der im schwach dotierten Gebiet gespeicherten Ladungsträger bestimmt. Je mehr Ladungsträger vorliegen, desto höher ist der Ausräumstrom. Ein höherer Ausräumstrom bedeutet eine höhere Abschaltverlustleistung. Aus der Integration des Abschaltstroms über die Zeit erhält man die Speicherladung Qrr (Reverse Recovery Charge), die eine wichtige Größe zur Beschreibung der Abschaltverlustleistung ist und möglichst klein sein soll. Schaltzeiten und Schaltverluste sind bei PiN-Dioden hoch.

Eine Verbesserung des Schaltverhaltens bieten Schottky-Dioden (Metall-Halbleiterkontakte bzw. Silizid-Halbleiterkontakte). Bei Schottky-Dioden findet keine Hochinjektion im Flussbetrieb statt. Daher entfällt das Ausräumen der Minoritätsladungsträger. Schottky-Dioden schalten schnell und nahezu verlustlos. Allerdings sind für hohe Sperrspannungen wieder dicke und niedrig dotierte Halbleiterschichten notwendig, was bei hohen Strömen zu nicht akzeptablen, hohen Flussspannungen führt. Deswegen sind Leistungs-Schottky-Dioden in Silizium-Technik trotz guten Schaltverhaltens für Sperrspannungen über etwa 100 V nicht geeignet.

In der DE 197 40 195 C2 wird ein Halbleiterbauelement beschrieben, das nachfolgend stets als Cool SBD-Diode bezeichnet wird. Bei dieser Diode wird durch das Einbringen von dotierten, alternierend angeordneten p- und n-leitenden Säulen unter einem Schottky-Kontakt eine nahezu beliebige Absenkung des Widerstandes möglich. Wenn die Säulenbreite reduziert wird, können die Säulendotierungen erhöht werden. Dabei ist die Dotierung der p- und n-Säulen so gewählt, dass bei einem Anliegen einer Sperrspannung alle Dotieratome ionisiert sind. Dieses Prinzip wird auch als Superjunction-Prinzip (SJ) bezeichnet. Da über die p-dotierten Säulen eine gewisse Minoritätsladungsträgerinjektion stattfindet, wird das ideale Schaltverhalten einer reinen Schottky-Diode nicht erreicht, gegenüber einer PiN-Diode aber deutlich verbessert. Die geringe Flussspannung der PiN-Diode wird aber bei hohen Strömen nicht erreicht. Das Superjunction-Prinzip ist beispielsweise in der Zeitschrift Japanese Journal of Applied Physics, Vol. 36, Seiten 6254 - 6262, beschrieben.

Aus der US 2010/0237456 A1 ist eine Halbleiteranordnung mit einer Trench-MOS-Barrier-Schottky-Diode bekannt, die wenigstens eine Kombination von Schottky-Diode, MOS-Struktur und einer PN-Diode als Klammerelement umfasst. Die PN-Diode ist als integrierte Substrat-PN-Diode ausgestaltet. Die Durchbruchsspannung der Substrat-PN-Diode ist niedriger als die Durchbruchsspannung der Schottky-Diode und die Durchbruchsspannung der MOS-Struktur.

Aus der Zeitschrift IEEE Electronic Device Letters, vol. 20, No. 12, December 1999, Seiten 627 - 629, ist ein Schottky-Gleichrichter bekannt, der ein n+-Substrat, eine über dem n+-Substrat angeordnete n-Epischicht und in die n-Epischicht eingebrachte, mit p+-Material gefüllte Gräben aufweist. Die Seitenwände der Gräben enthalten jeweils eine Oxidschicht, durch welche das in den Gräben vorgesehene p+-Material von der seitlich benachbarten n-Epischicht getrennt ist.

Aus der US 6,590,240 B1 ist eine weitere Halbleiteranordnung bekannt, welche ein n+-Substrat, eine über dem n+-Substrat angeordnete n-Epischicht und in die n-Epischicht eingebrachte, mit p-Material gefüllte Gräben aufweist. Auch bei dieser Anordnung sind die Seitenwände der Gräben mit einer Oxidschicht versehen, durch welche das in den Gräben befindliche p-Material von der jeweils seitlich benachbarten n-Epischicht getrennt ist.

Die Veröffentlichung "Design consideration of 1000V merged PiN Schottky diode using superjunction sustaining layer", E. Napoli et. al, Proceedings von ISPSD 2001 zeigt eine Diode, die aus der Kombination einer PiN Diode und einer Schottky Diode besteht. Die Diode weist alternierend angeordnete p- und n-leitenden Säule auf und funktioniert gemäß dem Superjunction-Prinzip.

Aus der US 5,216,275 sind mehrere Superjunction-Halbleiteranordnungen bekannt. Alternierend angeordnete p- und n-leitenden Säule werden erzeugt, indem Gräben in einer Epischicht geätzt und mit Halbleitermaterial des entgegengesetzten Leitungstyps gefüllt werden. Es ist dabei nicht notwendig eine zwischen benachbarten Säulen ggf. vorhandene dielektrische Schicht zu entfernen. Wenn vorhanden, wirkt sich eine solche Schicht positiv auf das Herstellungsverfahren aus.

### Offenbarung der Erfindung

Bei einem Halbleiterchip mit den im Anspruch 1 angegebenen Merkmalen handelt es sich im Unterschied zu den vorstehend beschriebenen Halbleiteranordnungen um eine Super-Junction-Schottky-Oxid-PiN-Diode.

Diese weist ein n⁺-dotiertes Substrat auf, über dem sich eine n-dotierte Epischicht mit in die Epischicht eingebrachten, mit p-dotiertem Halbleitermaterial gefüllten Gräben, die an ihrer Oberseite jeweils einen hoch p-dotierten Bereich aufweisen, derart befindet, dass eine alternierende Anordnung von n-dotierten Bereichen mit einer ersten Breite und p-dotierten Bereichen mit einer zweiten Breite vorliegt, wobei des Weiteren an der Vorderseite des Halbleiterchips eine erste Metallschicht vorgesehen ist, die einen Schottky-Kontakt mit der n-dotierten Epischicht und einen ohmschen Kontakt mit den hoch p-dotierten Bereichen bildet und als Anodenelektrode dient, an der Rückseite des Halbleiterchips eine zweite Metallschicht vorgesehen ist, die einen ohmschen Kontakt darstellt und als Kathodenelektrode dient und wobei zwischen einem n-dotierten Bereich und einem benachbarten p-dotierten Bereich jeweils eine dielektrische Schicht vorgesehen ist.

Dadurch wird in vorteilhafter Weise eine hochsperrende Hochvolt-Diode mit niedriger Flussspannung und günstigem Schaltverhalten zur Verfügung gestellt. Eine Diode gemäß der Erfindung, die auch als Super-Junction-Schottky-Oxid-PiN-Diode bezeichnet wird, stellt eine Kombination einer Schottky-Diode mit einer PiN-Diode dar, die zusammen eine Superjunction-Struktur bilden und voneinander galvanisch getrennt sind. Eine Diode gemäß der Erfindung weist im Vergleich zu herkömmlichen PiN-Leistungsdioden bei ähnlich niedrigen Flussspannungen deutlich geringere Abschaltverluste auf.

Eine Diode gemäß der Erfindung stellt eine Trenchstruktur mit parallel geschalteten Schotty- und PiN-Dioden dar, bei denen die Schotty- und PiN-Bereiche galvanisch voneinander getrennt sind und Ladungsträgerkompensation bzw. Superjunction-Struktur aufweisen. Durch die galvanische Trennung von Schottky- und PiN-Struktur tritt in den PiN-Bereichen eine Hochinjektion auf. Bei nahezu gleichen Abschaltverlusten ist die Flussspannung geringer als bei einer bekannten Cool SBD-Diode.

Im Vergleich zu einer Hochspannungs-PiN-Diode weist eine erfindungsgemäße Diode eine deutlich kleinere Abschaltverlustleistung bei vergleichbarer Flussspannung und hohen Stromdichten auf.

Im Vergleich zu einer Cool SBD-Diode weist eine erfindungsgemäße Diode eine niedrigere Flussspannung bei hoher Stromdichte und einer nur unwesentlich höheren Abschaltverlustleistung auf.

Nachfolgend wird die Erfindung anhand der Zeichnung näher erläutert. Es zeigt
- Figur 1: eine Querschnittsdarstellung eines Ausschnitts einer bekannten Cool SBD-Diode,
- Figur 2: eine Querschnittsdarstellung eines Ausschnitts einer erfindungsgemäßen Diode,
- Figur 3: ein Diagramm, in welchem Durchlasskennlinien veranschaulicht sind,
- Figur 4: ein Diagramm, in welchem Ladungsträgerverteilungen in der p-dotierten Epischicht veranschaulicht sind,
- Figur 5: ein Diagramm, in welchem Ladungsträgerverteilungen in der n-dotierten Epischicht veranschaulicht sind,
- Figur 6: ein Diagramm, in welchem das Abschaltverhalten veranschaulicht ist,
- Figur 7: eine Querschnittsdarstellung eines Ausschnitts einer erfindungsgemäßen Diode gemäß einem zweiten Ausführungsbeispiel,
- Figur 8: eine Querschnittsdarstellung eines Ausschnitts einer Diode gemäß einem nicht erfindungsgemäßen Beispiel und
- Figur 9: eine Querschnittsdarstellung eines Ausschnitts einer Diode gemäß einem nicht erfindungsgemäßen Beispiel.

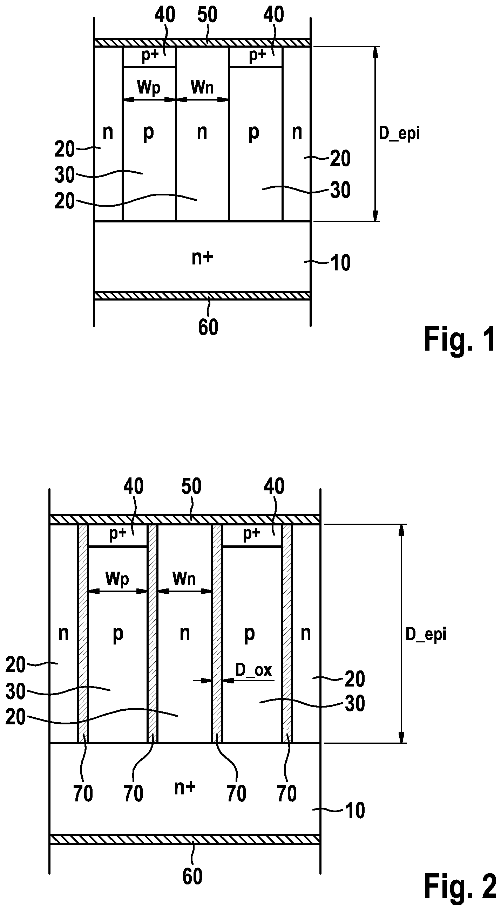

In der Figur 1 ist die dem Stand der Technik entsprechende Struktur einer CoolSBD ausschnittsweise im Querschnitt dargestellt. Die CoolSBD besteht aus einem n+-Substrat 10, auf dem eine n-Epischicht 20 der Dicke D_epi und der Dotierungskonzentration ND angeordnet ist. Die n-Epischicht 20 enthält eingeätzte Gräben (Trenchs) 30, die mit p-dotiertem Silizium der Dotierungskonzentration NA bzw. in den oberen Bereichen mit p+-dotiertem Silizium 40 gefüllt sind. Die Weite der n-Bereiche 20 ist Wn, die Weite der p- bzw. p+-Bereiche 30 bzw. 40 ist Wp. Dotierungen und Weiten sind so gewählt, dass die Bereiche bei Anliegen der vollen Sperrspannung verarmt sind (Superjunction Prinzip). Dies ist etwa bei NA·Wp = ND·Wn = 10¹² cm⁻² der Fall. Auf der Vorderseite des Chips sind die n-dotierten Bereiche 20 und die p+-dotierten Bereiche 40 mit einer durchgehenden ersten Metallschicht 50 bedeckt, die mit den n-dotierten Bereichen 20 einen Schottky-Kontakt und mit den p+-dotierten Bereichen 40 einen ohmschen Kontakt bildet. Die Metallschicht 50 stellt den Anodenkontakt der Diode dar. Durch Wahl eines entsprechenden Metalls 50 kann die Barrierenhöhe der Schottky-Diode 50-20 eingestellt werden. Beispielsweise kann als Metallschicht 50 Nickel bzw. NiSi verwendet werden. Über der funktionalen Schicht 50 können sich ggf. noch weitere - nicht eingezeichnete Metallschichten - befinden, um die Oberfläche beispielsweise lötfähig oder bondbar zu machen. Auf der Rückseite des Chips befindet sich eine zweite Metallschicht 60, die den ohmschen Kontakt zum hoch n+-dotierten Substrat 10 darstellt. Üblicherweise ist diese Schicht bzw. Schichtenfolge zur Löt- oder einer sonstigen Montage geeignet. Sie kann beispielsweise aus einer Abfolge von Cr / NiV und Ag bestehen. Die zweite Metallschicht 60 bildet den Kathodenanschluss.

Bei der gezeigten Struktur handelt es sich um eine Parallelschaltung einer Schottky- und einer PiN-Diode. Dabei bildet der Metallkontakt 50 mit den n-dotierten Säulen 20 Schottky-Dioden. Die PiN-Struktur wird durch die Schichtenfolge bestehend aus p+-Gebiet 40, p-Gebiet 30 und Substrat 10 als p+ / p / n+ - Struktur gebildet.

Bei Anliegen der Sperrspannung verarmen die p- und n-dotierten Säulen. Mit abnehmender Breite Wp und Wn kann die Dotierung - zumindest bis zu einer gewissen Grenze, die daraus resultiert, dass die Raumladungszonen schon bei kleiner Spannung zusammenstoßen - erhöht werden. Dies reduziert in Flussrichtung den Bahnwiderstand der Schottky-Dioden 50 - 20 - 10. Die Flussspannungen sind deshalb niedriger als bei einer einfachen Schottky-Diode, die bei gleicher Sperrspannung eine niedrigere Dotierung aufweist. Zusätzlich fließt in Flussrichtung noch etwas Strom durch die PiN-Dioden. Dadurch wird die Flussspannung weiter reduziert. Allerdings müssen die Minoritätsladungsträger beim Abschalten mit nachteiligen Effekten für die Schaltzeit auch wieder ausgeräumt werden.

Ein erfindungsgemäßes Ausführungsbeispiel einer Super-Junction-Schottky-Oxid-PiN-Diode (SJSOP) ist in der Figur 2 ausschnittsweise im Querschnitt dargestellt. Die SJSOP besteht aus einem n+-Substrat 10, auf dem eine n-Epischicht 20 der Dicke D_epi angeordnet ist. Die n-Epischicht 20 enthält eingeätzte Gräben (Trenchs) 30, die mit p-dotiertem Silizium und an der Oberseite mit p⁺-dotiertem Silizium 40 gefüllt sind. Die Weite der n-Bereiche 20 beträgt Wn, die der p- bzw. p+-Bereiche 30 bzw. 40 beträgt Wp. Wiederum sind die Dotierungskonzentrationen und Weiten so gewählt, dass das Superjunction-Prinzip gilt. Im Gegensatz zu einer Anordnung gemäß der Figur 1 befinden sich zwischen den p/p+- und n-Bereichen dielektrische Schichten 70 - vorzugsweise SiO₂-Schichten - mit einer Dicke D_ox. Dadurch sind die p- und n-Bereiche nicht mehr direkt galvanisch verbunden. Auf der Vorderseite des Chips sind die n-dotierten Bereiche 20 und die p+-dotierten Bereiche 40 mit einer durchgehenden Metallschicht 50 bedeckt, die mit den n-dotierten Bereichen 20 einen Schottky-Kontakt und mit den p+-dotierten Bereichen 40 einen ohmschen Kontakt bildet. Die Metallschichten 50 und 60 stellen wiederum den Anoden- bzw. Kathodenkontakt der Diode dar. Aufbau und Funktion entsprechen der Anordnung gemäß der Figur 1.

Prinzip und Vorteil der erfindungsgemäßen Struktur gemäß der Figur 2 gegenüber der bekannten Struktur nach Figur 1 werden am Beispiel von 600 V-Dioden verglichen. Dazu werden Bauelemente mit einer aktiven Chipfläche von 26mm² und einer Chipdicke von 200 µm aus Silizium betrachtet. Die Dotierung des Substrats 10 beträgt 10¹⁹ cm⁻³. Die Dotierkonzentration NA der n-dotierten Bereiche bzw. Säulen 20 und der p-dotierten Bereiche bzw. Säulen 30 ist identisch und beträgt 10¹⁶ cm⁻³. Die alternierend angeordneten n- und p-Säulen haben eine Dicke D_epi von 35 µm. Die entsprechenden Weiten Wp und Wn betragen jeweils 1 µm. Die p+-Aufdotierung 40 ist eine Gaußverteilung mit einer Oberflächenkonzentration von 5.10¹⁹cm⁻³ bei einer Eindringtiefe von etwa 0,5 µm. Die Barriere des Schottky-Kontakts, der aus dem Vorderseitenmetall 50 und den n-dotierten Säulen 20 gebildet wird, beträgt 0,72 eV. Die in der erfindungsgemäßen Struktur zusätzlich vorhandenen Oxidschichten 70 haben eine Dicke D_ox von 50 nm.

Die CoolSBD und die SJSOP werden zusätzlich noch mit einer 600V PiN-Diode gleicher Fläche und Chipdicke verglichen. Die n-dotierte Epidicke beträgt 52µm und hat eine Dotierkonzentration von 3,1.10¹⁴ cm⁻³. Die p-dotierte Anode weist wieder eine Gaußverteilung mit einer Oberflächenkonzentration von 5.10¹⁹ cm⁻³ bei einer Eindringtiefe von 5 µm auf.

Bei vergleichbaren Durchbruchsspannungen (650V) sind die Sperrströme von SJSOP und CoolSBD vergleichbar, allerdings wegen der gewählten Schottky-Barriere um ein bis zwei Größenordnungen höher als bei der PiN-Diode.

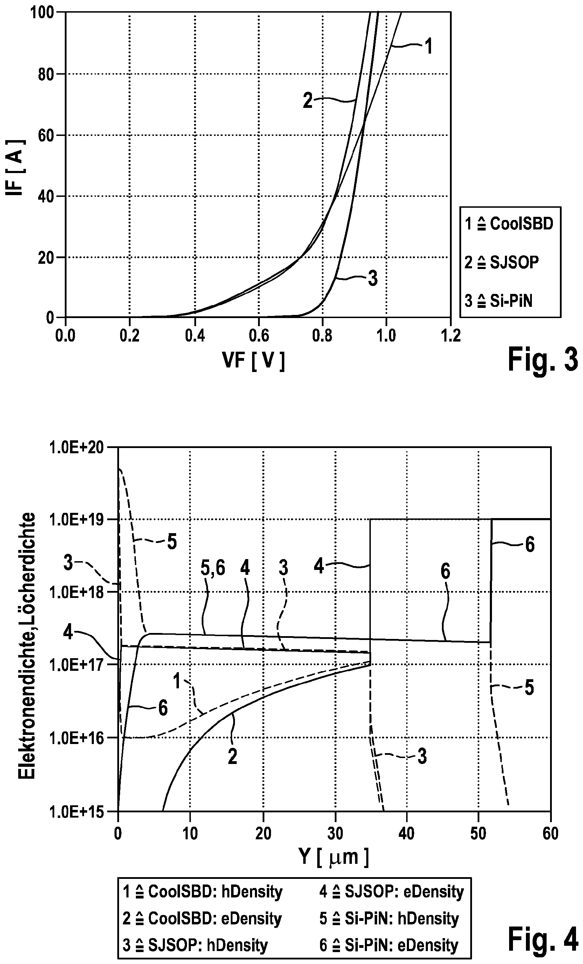

Die Durchlassspannungen - gemessen bei hohen Strömen, z. B. bei 100 A - einer SJSOP sind vergleichbar mit der PiN-Diode, aber geringer als bei der bekannten CoolSBD. Dies ist in der Figur 3 dargestellt, in welcher längs der Abszisse die Flussspannung VF und längs der Ordinate der Flussstrom IF aufgetragen sind.

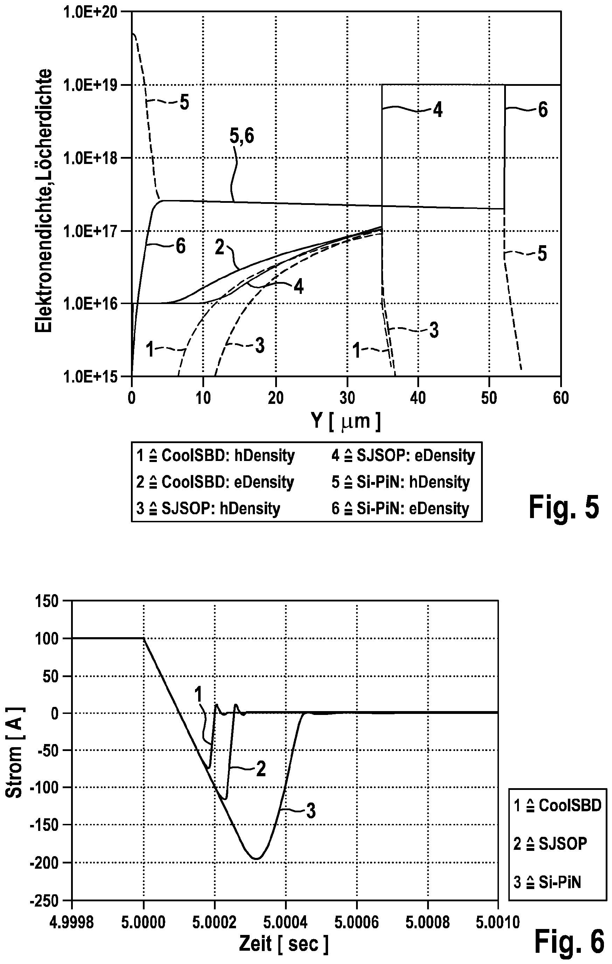

Das verbesserte Verhalten der SJSOP in Durchlassrichtung lässt sich mit der überraschenden Erkenntnis erklären, dass bei der neuartigen Struktur - im Gegensatz zur CoolSBD - über die gesamte p-dotierte Säule, genau wie bei einer PiN-Diode, Hochinjektion herrscht. Dabei verhindern die Oxidschichten 70 einen Abfluss von Ladungsträgern in die benachbarten n-dotierten Gebiete 20. Abgeflossene Ladungsträger stehen für Hochinjektion nicht mehr zur Verfügung. Die Ursache der Ladungsverschiebung einer CoolSBD ist in den unterschiedlichen Schleusenspannungen einerseits der Schottky-Diode 50 - 20 und anderseits der PiN-Diode 30 - 10 zu suchen. Dabei wird vorausgesetzt, dass die Schleusenspannung der Schottky-Diode niedriger als die der PiN-Diode ist. Die berechneten Ladungsträgerverteilungen im p- und n-dotierten Gebiet sind in den Figuren 4 und 5 illustriert. Dort ist jeweils längs der Abszisse die vertikale Erstreckung Y, beginnend am unteren Rand der ersten Metallschicht 50, und längs der Ordinate die Elektronendichte (eDensity) und die Löcherdichte (hDensity) aufgetragen. Man erkennt, dass im n-Gebiet zwischen CoolSBD und SJSOP kaum Unterschiede bestehen, bei der neuartigen SJSOP das gesamte p-Gebiet aber mit Elektronen und Löchern überflutet ist.

Wegen der höheren Minoritätsladungsträgerkonzentration (Elektronen in den schwach p-dotierten Gebieten 30) ist das Schaltverhalten einer erfindungsgemäßen Diode etwas ungünstiger als bei der CoolSBD, allerdings wesentlich besser als bei einer PiN-Diode. Dieser Sachverhalt ist in der Figur 6 veranschaulicht, in welcher längs der Abszisse die Zeit und längs der Ordinate der Strom aufgetragen ist.

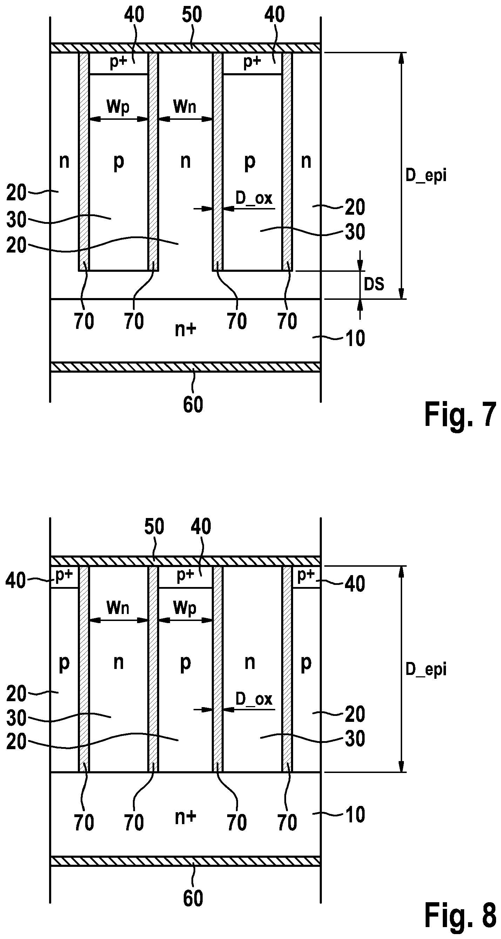

Eine Querschnittsdarstellung eines Ausschnitts einer erfindungsgemäßen Diode gemäß einem zweiten Ausführungsbeispiel ist in der Figur 7 dargestellt. Im Gegensatz zur Anordnung nach der Figur 2 enden die p-dotierten Gebiete 30 und die Oxidschichten 70 nicht am n / n⁺ -Übergang 20 - 10, sondern in einem gewissen Abstand DS darüber.

Grundsätzlich ist die Erfindung nicht auf mit p-dotiertem Halbleitermaterial gefüllte Gräben in einer n-dotierten Epischicht beschränkt. An Stelle der n-dotierten Epischicht kann, wie es aus der Figur 8 ersichtlich ist, die ein Beispiel zeigt, welches nützlich ist, um die Erfindung zu verstehen, auch eine p-dotierten Epischicht 20, die an der Oberfläche einen hoch p-dotierten Bereich 40 aufweist, vorliegen, in die mit n-dotiertem Halbleitermaterial gefüllte Gräben 30 eingebracht sind. Dabei sind wiederum die n- und p-dotierten Bereiche galvanisch durch eine dielektrische Schicht 70 getrennt. Dabei muss die gefüllte n-dotierte Schicht am Boden des Grabens 30 mit dem hoch n-dotierten Substrat 10 galvanisch verbunden sein.

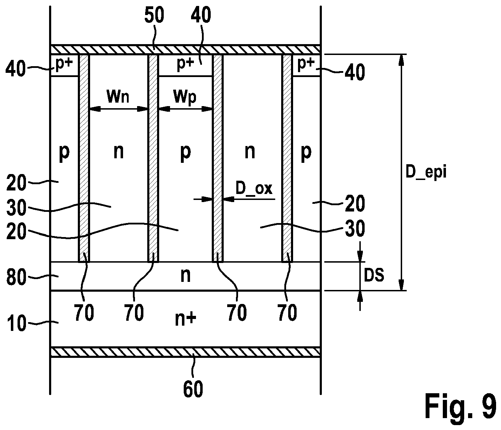

Für den Fall, dass die p-dotierte Epischicht 20 analog zu Fig. 7 nicht am hoch n-dotierten Substrat 10, sondern in einem Abstand (DS) davon endet, muss sich zwischen der p-dotierten Epischicht 20 und dem hoch n-dotierten Substrat 10 noch eine weitere n-dotierte Schicht 80 befinden, an die die gefüllte n-dotierte Schicht 30 anschließt. Dies ist in der Figur 9 veranschaulicht, die ein weiteres Beispiel zeigt, welches nützlich ist, um die Erfindung zu verstehen.

## Patentansprüche

1. Halbleiterchip, mit
- einem n⁺-dotierten Substrat (10), über dem sich eine n-dotierte Epischicht (20) mit in die Epischicht eingebrachten, mit p-dotiertem Halbleitermaterial gefüllten Gräben (30), die an ihrer Oberseite jeweils einen hoch p-dotierten Bereich (40) aufweisen, derart befindet, dass eine alternierende Anordnung von n-dotierten Bereichen (20) mit einer ersten Breite (Wn) und p-dotierten Bereichen (30) mit einer zweiten Breite (Wp) vorliegt,
- einer an der Vorderseite des Halbleiterchips vorgesehenen ersten Metallschicht (50), die einen Schottky-Kontakt mit der n-dotierten Epischicht (20) und einen ohmschen Kontakt mit den hoch p-dotierten Bereichen (40) bildet und als Anodenelektrode dient,
- einer an der Rückseite des Halbleiterchips vorgesehenen zweiten Metallschicht (60), die einen ohmschen Kontakt darstellt und als Kathodenelektrode dient, wobei
- zwischen einem n-dotierten Bereich (20) und einem benachbarten p-dotierten Bereich (30) jeweils eine dielektrische Schicht (70) vorgesehen ist,
wobei
- eine Kombination einer Schottky-Diode mit einer PiN-Diode, die galvanisch voneinander getrennt sind, vorliegt, die zusammen eine Superjunction-Struktur bilden, so dass beim Anliegen einer Sperrspannung alle Dotieratome der n-dotierte Bereiche (20) und der p-dotiertem Bereiche (30) ionisiert sind und wobei in Durchlassrichtung in der PiN-Diode eine Hochinjektion auftritt, bei der die injizierten Minoritätsladungsträger die Dotierkonzentration der p-dotierten Bereiche (30) übersteigt.

2. Halbleiterchip nach Anspruch 1, **dadurch gekennzeichnet, dass** die mit p-dotiertem Halbleitermaterial gefüllten Gräben (30) an ihrer Unterseite jeweils mit dem n⁺-dotierten Substrat (10) kontaktiert sind.

3. Halbleiterchip nach Anspruch 1, **dadurch gekennzeichnet, dass** die Unterseite der mit p-dotiertem Halbleitermaterial gefüllten Gräben (30) jeweils einen Abstand (DS) von dem n⁺-Substrat (10) aufweisen.

4. Halbleiterchip nach einem der vorhergehenden Ansprüche, **dadurch gekennzeichnet, dass** die Breite und die Dotierung der n-dotierten Bereiche (20) und der p-dotierten Gräben (30) derart gewählt sind, dass diese Gebiete beim Vorliegen der maximalen Sperrspannung vollständig verarmt sind.

5. Halbleiterchip nach einem der vorhergehenden Ansprüche, **dadurch gekennzeichnet, dass** die dielektrischen Schichten (70) Siliziumdioxidschichten sind.

6. Halbleiterchip nach einem der vorhergehenden Ansprüche, **dadurch gekennzeichnet, dass** die erste Breite (Wn) der n-dotierten Bereiche (20) und die zweite Breite (Wp) der p-dotierten Bereiche (30) im Bereich zwischen 1 µm und 4 µm liegt, die Tiefe der n-dotierten Bereiche (20) und der p-dotierten Bereiche (30) zwischen 30 µm und 80 µm liegt und die Breite der dielektrischen Schichten (70) im Bereich zwischen 10 nm und 100 nm liegt.

7. Halbleiterchip nach einem der vorhergehenden Ansprüche, **dadurch gekennzeichnet, dass** die p-dotierten Gräben (30) in Streifenanordnung oder in Form von Inseln angeordnet sind.

8. Halbleiterchip nach einem der vorhergehenden Ansprüche, **dadurch gekennzeichnet, dass** die p-dotierten Gräben (30) in die n-dotierte Epischicht (20) eingeätzt sind.

9. Halbleiterchip nach einem der vorhergehenden Ansprüche, **dadurch gekennzeichnet, dass** er in einem Einpressdiodengehäuse realisiert ist.

10. Halbleiterchip nach einem der vorhergehenden Ansprüche, **dadurch gekennzeichnet, dass** er Bestandteil eines Gleichrichters eines Kraftfahrzeuggenerators ist.

## Claims

1. Semiconductor chip, comprising
- an n⁺-doped substrate (10), above which is situated an n-doped epitaxial layer (20) having trenches (30) introduced into the epitaxial layer and filled with p-doped semiconductor material, said trenches each having a highly p-doped region (40) at their top side, in such a way that an alternating arrangement of n-doped regions (20) having a first width (Wn) and p-doped regions (30) having a second width (Wp) is present,
- a first metal layer (50) provided at the front side of the semiconductor chip, said first metal layer forming a Schottky contact with the n-doped epitaxial layer (20) and an ohmic contact with the highly p-doped regions (40) and serving as an anode electrode,
- a second metal layer (60) provided at the rear side of the semiconductor chip, said second metal layer constituting an ohmic contact and serving as a cathode electrode, wherein
- a respective dielectric layer (70) is provided between an n-doped region (20) and an adjacent p-doped region (30), wherein
- a combination of a Schottky diode with a PiN diode, which are galvanically isolated from one another, is present, which diodes together form a superjunction structure, such that all doping atoms of the n-doped regions (20) and of the p-doped regions (30) are ionized when a reverse voltage is present, and wherein a high level injection in which the injected minority charge carriers exceed the doping concentration of the p-doped regions (30) occurs in the forward direction in the PiN diode.

2. Semiconductor chip according to Claim 1, **characterized in that** the trenches (30) filled with p-doped semiconductor material are each contacted with the n⁺-doped substrate (10) at their underside.

3. Semiconductor chip according to Claim 1, **characterized in that** the underside of the trenches (30) filled with p-doped semiconductor material is in each case at a distance (DS) from the n⁺-type substrate (10).

4. Semiconductor chip according to any of the preceding claims, **characterized in that** the width and the doping of the n-doped regions (20) and of the p-doped trenches (30) are chosen in such a way that these regions are fully depleted when the maximum reverse voltage is present.

5. Semiconductor chip according to any of the preceding claims, **characterized in that** the dielectric layers (70) are silicon dioxide layers.

6. Semiconductor chip according to any of the preceding claims, **characterized in that** the first width (Wn) of the n-doped regions (20) and the second width (Wp) of the p-doped regions (30) are in the range of between 1 µm and 4 µm, the depth of the n-doped regions (20) and of the p-doped regions (30) is between 30 µm and 80 µm, and the width of the dielectric layers (70) is in the range of between 10 nm and 100 nm.

7. Semiconductor chip according to any of the preceding claims, **characterized in that** the p-doped trenches (30) are arranged in a strip arrangement or in the form of islands.

8. Semiconductor chip according to any of the preceding claims, **characterized in that** the p-doped trenches (30) are etched into the n-doped epitaxial layer (20) .

9. Semiconductor chip according to any of the preceding claims, **characterized in that** it is realized in a press-fit diode housing.

10. Semiconductor chip according to any of the preceding claims, **characterized in that** it is part of a rectifier of a motor vehicle generator.

## Revendications

1. Puce en semiconducteur, comprenant
- un substrat dopé N⁺ (10) sur lequel se trouve une couche épitaxiale dopée N (20), comprenant des tranchées (30) remplies de matériau semiconducteur dopé P pratiquées dans la couche épitaxiale, lesquelles possèdent respectivement sur leur côté supérieur une zone fortement dopée P (40), de telle sorte qu'il existe un arrangement en alternance de zones dopées N (20) ayant une première largeur (Wn) et de zones dopées P (30) ayant une deuxième largeur (Wp),
- une première couche métallique (50) disposée au niveau du côté avant de la puce en semiconducteur, laquelle forme un contact Schottky avec la couche épitaxiale dopée N (20) et un contact ohmique avec les zones fortement dopées P (40) et sert d'électrode d'anode,
- une deuxième couche métallique (60) disposée au niveau du côté arrière de la puce en semiconducteur, laquelle représente un contact ohmique et sert d'électrode de cathode,
- une couche diélectrique (70) se trouvant respectivement entre une zone dopée N (20) et une zone dopée P (30) voisine,
- une combinaison d'une diode Schottky avec une diode PiN, lesquelles sont séparées galvaniquement l'une de l'autre, étant présente, lesquelles forment ensemble une structure de superjonction de sorte que lors de l'application d'une tension inverse, tous les atomes dopés des zones dopées N (20) et des zones dopées P (30) sont ionisés et une forte injection se produisant dans le sens passant dans la diode PiN, lors de laquelle les porteurs de charge minoritaires injectés dépassent la concentration de dopant des zones dopées P (30).

2. Puce en semiconducteur selon la revendication 1, **caractérisée en ce que** les tranchées (30) remplies de matériau semiconducteur dopé P sont mises en contact au niveau de leur côté inférieur respectivement avec le substrat dopé N⁺ (10).

3. Puce en semiconducteur selon la revendication 1, **caractérisée en ce que** le côté inférieur des tranchées (30) remplies de matériau semiconducteur dopé P présente respectivement un écart (DS) par rapport au substrat dopé N⁺ (10).

4. Puce en semiconducteur selon l'une des revendications précédentes, **caractérisée en ce que** la largeur et le dopage des zones dopées N (20) et des tranchées dopées P (30) sont choisis de telle sorte que ces régions sont entièrement appauvries en présence de la tension inverse maximale.

5. Puce en semiconducteur selon l'une des revendications précédentes, **caractérisée en ce que** les couches diélectriques (70) sont des couches en dioxyde de silicium.

6. Puce en semiconducteur selon l'une des revendications précédentes, **caractérisée en ce que** la première largeur (Wn) des zones dopées N (20) et la deuxième largeur (Wp) des zones dopées P (30) sont comprises dans la plage entre 1 µm et 4 µm, la profondeur des zones dopées N (20) et des zones dopées P (30) est comprise entre 30 µm et 80 µm et la largeur des couches diélectriques (70) est comprise dans la plage entre 10 nm et 100 nm.

7. Puce en semiconducteur selon l'une des revendications précédentes, **caractérisée en ce que** les tranchées dopées P (30) sont disposées selon un arrangement en bandes ou sous la forme d'îlots.

8. Puce en semiconducteur selon l'une des revendications précédentes, **caractérisée en ce que** les tranchées dopées P (30) sont gravées dans la couche épitaxiale dopée N (20).

9. Puce en semiconducteur selon l'une des revendications précédentes, **caractérisée en ce qu'**elle est réalisée dans un boîtier de diode injecté.

10. Puce en semiconducteur selon l'une des revendications précédentes, **caractérisée en ce qu'**elle est un élément constitutif d'un redresseur d'un générateur de véhicule automobile.
